# EUROPEAN PATENT APPLICATION

(11) **EP 3 038 152 A1**
(43) Date of publication of application: **29.06.2016**
(21) Application number: 15198914.2
(22) Date of filing: 10.12.2015
(51) Int. Cl.: H01L 23/373, H01L 23/473

(54) **WIRING BOARD AND SEMICONDUCTOR PACKAGE INCLUDING WIRING BOARD**

(30) Priority: 26.12.2014 JP 2014265332
(71) Applicant: Kabushiki Kaisha Toshiba, Minato-ku Tokyo 105-8001 (JP)
(72) Inventor: Kodani, Kazuya, Tokyo, Aomori 105-8001 (JP); Ichikura, Yuta, Tokyo, Aomori 105-8001 (JP); Tada, Nobumitsu, Tokyo, Aomori 105-8001 (JP); Ito, Hiroaki, Tokyo, Aomori 105-8001 (JP); Ohbu, Toshiharu, Tokyo, Aomori 105-8001 (JP); Koyama, Taihei, Tokyo, Aomori 105-8001 (JP); Yuuki, Kazuaki, Tokyo, Aomori 105-8001 (JP); Nakazawa, Yosuke, Tokyo, Aomori 105-8001 (JP); Yamamoto, Atsushi, Tokyo, Aomori 105-8001 (JP); Otani, Makoto, Tokyo, Aomori 105-8001 (JP); Ueda, Kazuhiro, Tokyo, Aomori 105-8001 (JP); Iguchi, Tomohiro, Tokyo, Aomori 105-8001 (JP)
(74) Representative: Awapatent AB

(57) **Abstract**

According to an embodiment, a wiring board includes an insulating board including a heat transfer region made of silicon nitride and having a thickness in a range between 0.2 mm and 1 mm; and a wiring layer including a pad stacked on the heat transfer region and made of a metal material having a thickness of 1.5 mm or more.

## Description

### FIELD

Embodiments relate to a wiring board and a semiconductor package including the wiring board.

### BACKGROUND

A semiconductor package includes, for example, a semiconductor circuit board and a sealing member for sealing the semiconductor circuit board. The semiconductor circuit board comprises, for example: a conductive base material including an insulating base material, such as ceramic or resin; metallic foil fixed on both sides or one side of the insulating base material; and a circuit including a semiconductor device fixed to one side of the conductive base material by solder, or the like.

For example, a power semiconductor device such as an insulated gate bipolar transistor (IGBT) generates heat by switching. Thus, the semiconductor circuit board is fixed to come into contact with a heatsink via a spreader panel which spreads heat, and is cooled.

In recent years, the power semiconductor has been required to have a characteristic of high-speed switching under a high voltage and a high current. Since the high-speed switching under a high current generates a large amount of heat, a semiconductor circuit including a power semiconductor is desired to have improved heat radiation performance and cooling performance. In addition, as hybrid cars and electric vehicles, etc. have come into actual use, miniaturization, weight savings, and price reduction of the power semiconductor module are desired.

### BRIEF DESCRIPTION OF THE DRAWINGS

FIG. 1 is a cross-sectional view illustrating an example of the configuration of a wiring board and a semiconductor package of a first embodiment.
FIG. 2 shows a result of comparison between a plurality of ceramic materials regarding heat radiation performance, mechanical properties, and erosion resistance.
FIG. 3 shows an example of the relationship between the thickness and heat radiation performance of the pad of the wiring board and the semiconductor package of the embodiments.
FIG. 4 shows an example of the relationship between the thickness and heat radiation performance of a heat transfer region of a wiring board and a semiconductor package of the embodiments.
FIG. 5 is a cross-sectional view illustrating an example of the configuration of a wiring board and a semiconductor package of a second embodiment.
FIG. 6 is a cross-sectional view illustrating an example of the configuration of a wiring board and a semiconductor package of a third embodiment.

### DETAILED DESCRIPTION

In general, according to one embodiment a wiring board comprises an insulating board including a heat transfer region made of silicon nitride and having a thickness in a range between 0.2 mm and 1 mm; and a wiring layer including a pad stacked on the heat transfer region and made of a metal material having a thickness of 1.5 mm or more.

Hereinafter, a wiring board and a semiconductor package including the wiring board according to embodiments will be described with reference to the drawings.

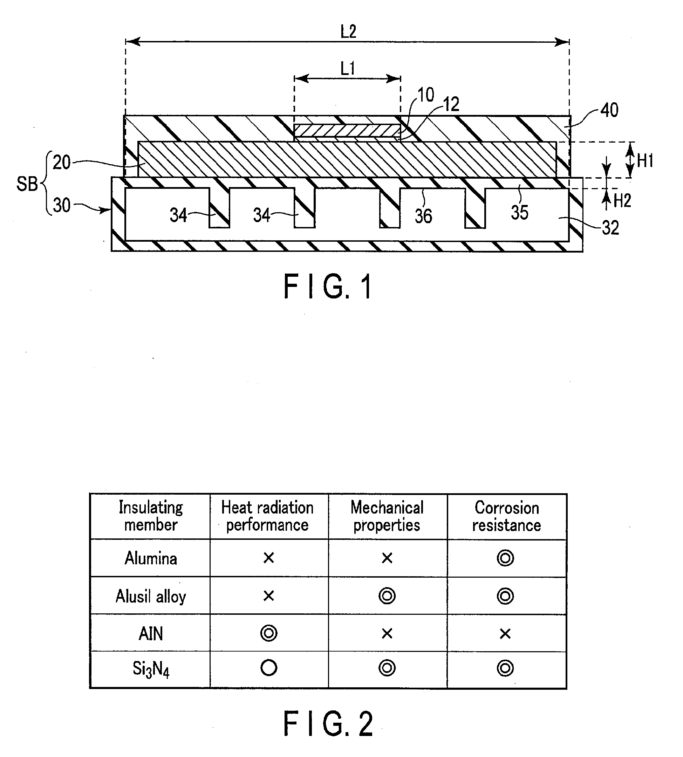

FIG. 1 is a cross-sectional view illustrating an example of the configuration of a wiring board and a semiconductor package of a first embodiment.

The semiconductor package of the present embodiment includes a semiconductor device 10, a wiring board SB, and a sealing body 40. The wiring board SB includes a pad 20 and an insulating board 30.

The semiconductor device 10 includes various semiconductor devices used for an electric circuit, such as an insulated gate bipolar transistor (IGBT), a field-effect transistor (FET), a gate turn-off thyristor (GTO), a semiconductor switch such as a transistor, and a diode. The semiconductor device 10 is fixed to a surface of the pad 20 by, for example, solder 12.

The pad 20 is a part of a wiring layer formed by patterning a conductive material such as aluminum and a copper material used for circuit wiring. In the present embodiment, the pad 20 is made of, for example, copper. The pad 20 is directly joined to, for example, a heat transfer region 35 of the insulating board 30 to be described later, or brazed onto a surface of the heat transfer region 35. The pad 20 may be patterned on the insulating board 30 to form a part of a circuit including the semiconductor device 10, and may include a connecting pad connected to a lead which externally supplies a current. The pad 20 is a heat spreader for spreading heat generated in the semiconductor device 10 in a board surface direction of the insulating board 30 (direction orthogonal to the direction in which the semiconductor device 10, pad 20, and insulating board 30 are stacked), and may be separately provided on one surface or both surfaces of the insulating board 30.

The insulating board 30 includes a flow path 32, a plurality of protrusions 34, and a heat transfer region 35.

The heat transfer region 35 is a part of the insulating board 30 to which the pad 20 is joined, and includes a surface to which the pad 20 is joined and a cooling surface 36 opposed to the surface to which the pad 20 is joined. The heat transfer region 35 is located between the cooling surface 36 and the surface of the insulating board 30 which is in contact with the pad 20.

The protrusions 34 are provided on the surface of the heat transfer region 35 on which the pad 20 is stacked, and are a part of the insulating board 30 which protrudes from the cooling surface 36 of the heat transfer region 35. The protrusions 34 protrude toward the flow path 32 from the cooling surface 36 except for the protrusions 34, which is regarded as a reference surface. The protrusions 34 are formed integrally with the heat transfer region 35 of the insulating board 30. The protrusions 34 may be separated from the heat transfer region 35 and, when a cooling method utilizing a high-speed flow, such as a jet flow or a vertical flow is adopted, the protrusions 34 may be omitted.

The flow path 32 is a gap for allowing a cooling medium provided in the insulating board 30 to pass through. Namely, the insulating board 30 includes therein a gap serving as a flow path, and a cylinder having a surface opposed to the surface on which the pad 20 is stacked (cooling surface 36) as a part of an inner surface.

The insulating board 30 is formed by sheeting and sintering a powder material. In the present embodiment, the insulating board 30 is made of a sheet of ceramic such as silicon nitride (SiN), and may be made by stacking the sheets. It is desirable that the material of the insulating board 30 has low heat resistance, and has strength sufficient for joining to the pad 20.

Conventionally, heat generated in the semiconductor device 10 has been radiated by spreading heat in the board direction; however, when the wiring board is miniaturized, heat cannot be sufficiently spread in the board direction for radiation. Thus, in the present embodiment, heat must be transferred to the cooling medium by increasing the heat transfer performance of the wiring board. In addition, the pressure and flow rate of the cooling medium must be increased to increase the cooling performance of the cooling medium. Accordingly, the material of the insulating board 30 should be of high heat transfer performance, high strength, and excellent erosion resistance.

Silicon nitride has high flexural strength and high stability in a high-temperature environment. Additionally, silicon nitride has higher heat conductivity than, for example, alumina (Al₂O₃) and resin. Thus, the insulating board 30 including the flow path 32 therein has a sufficient tolerance to increase the flow rate of the cooling medium and to boiling phenomena.

Moreover, in the present embodiment, the pad 20 is thickly formed as described later and thus, the pad 20 has a certain rigidity. Therefore, even when the pad 20 is attached to only one surface of the insulating board 30, bending of the wiring board SB can be prevented.

The following micro slurry jet erosion (MSE) test was conducted on aluminum, nickel plate, and silicon nitride, which are materials used for the surface of the flow path. Regarding the nickel plate, the MSE test was conducted on a normal material and an erosion-resistant material.

A test material of each material was prepared, and erosive wear was produced on a surface of the test material by projecting microscopic particles thereupon, so as to measure the strength of the material surface based on the fact that the progression rate of erosion varies depending on material strength.

As a result of the MSE test, it turned out that silicon nitride has higher wear resistance and higher erosion resistance than aluminum and nickel plate. Thus, when, for example, a cooling medium such as an ethylene glycol solution is used as the cooling medium, because silicon nitride has higher erosion resistance than aluminum and copper (nickel plate), forming the wiring board SB by silicon nitride enables an increase in pressure of the cooling medium and an increase in the flow rate of the cooling medium, and a wiring board SB with sufficient cooling performance can be realized.

FIG. 2 shows a result of comparison between ceramic materials regarding radiation performance, mechanical properties, and erosion resistance. Described herein are evaluation results on alumina, alusil alloy, aluminum nitride, and silicon nitride as ceramic materials. Alumina and alusil alloy have low heat conductivity and low heat radiation performance. Alumina and aluminum nitride have low flexural strength and lower mechanical properties than the other materials, and thus strength sufficient cannot be obtained for joining to the pad 20. Aluminum nitride has low fracture toughness and low erosion resistance, and may be eroded when used as a material for the surface of the flow path. In contrast, silicon nitride is excellent in all characteristics of radiation performance, mechanical properties, and erosion resistance, and is suitable as a material of the insulating board 30.

The sealing body 40 is an insulating body made of a resin, for example. The sealing body 40 covers and seals, for example, the semiconductor device 10 and the pad 20 of the semiconductor package by, for example, molding or potting. The sealing body 40 seals at least the semiconductor device 10 to prevent the semiconductor device 10 from coming into contact with water or air, thereby preventing deterioration of the semiconductor device 10. The sealing body 40 may be provided in such a manner as to expose a part of the pad 20.

The semiconductor device 10 employed in the semiconductor package of the present embodiment requires a predetermined time, for example, three seconds from start of a current flow to a rapid temperature rise. For example, when the semiconductor package of the present embodiment is used as a circuit of a vehicle-mounted inverter, a current flows in the semiconductor device 10 while an accelerator of a vehicle is pressed. The accelerator of a vehicle is rarely pressed for a long time. Hence, for efficient cooling of the semiconductor device 10, it is effective to suppress temperature rise for a predetermined time from start of a current flowing in the semiconductor device 10.

The semiconductor package of the present embodiment includes the solder 12, the pad 20, and the heat transfer region 35 between the semiconductor device 10, which is a heat source, and the cooling surface 36 of the insulating board 30, which comes into contact with the cooling medium. Thus, heat generated in the semiconductor device 10 is radiated to the pad 20, and further radiated to the heat transfer region 35 of the insulating board 30, and then cooled by the cooling medium. When a lead is connected to the pad 20, heat is generated at the connecting point between the lead and the pad 20 by a current which flows from the lead to the pad 20. Heat generated between the lead and the pad 10 is radiated to the pad 20, and further radiated to the heat transfer region 35 of the insulating board 30, and then cooled by the cooling medium.

When a member having a low heat transfer coefficient is included between the heat source and the cooling medium, heat flux disperses in a member in contact with the member having a low heat transfer coefficient. Therefore, as the volume of the member in contact with the member having a low heat transfer coefficient increases, more heat of the generated in the heat source can be absorbed. The heat generated in the heat source spreads over an area wider than the contact area of the heat source on the cooling surface in contact with the cooling medium, and the temperature of the cooling surface becomes lower than that of the heat source.

However, the semiconductor package of the present embodiment does not include a member having a low heat transfer coefficient between the heat source and the cooling surface 36 and, thus, heat generated in the heat source may be transfered to the cooling surface 36 without being substantially spread. If heat generated in the heat source is transfered to the cooling surface 36 without being spread, the cooling performance significantly decreases. In that case, only a part of the cooling surface 36 is used for heat exchange and thus, the cooling system requires an unnecessarily high pressure and high-speed flow of the cooling medium.

As described above, the semiconductor package of the present embodiment may be a low-efficient cooling system if heat generated in the heat source is transferred to the cooling surface 36 without being substantially spread. Thus, the inventors of the present application considered the heat radiation performance in each case with a different thickness (width in the stacking direction) H1 of the pad 20 and a different thickness (width in the stacking direction) H2 of the heat transfer region.

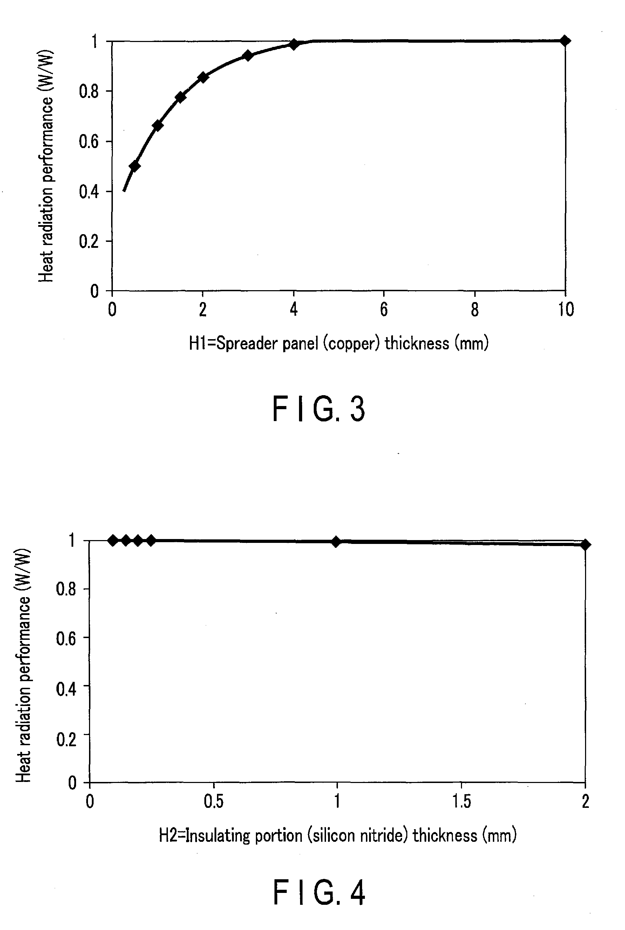

FIG. 3 shows an example of the relationship between the thickness and heat radiation performance of the pad of the wiring board, and the semiconductor package of the embodiments.

FIG. 3 shows a result of a simulation performed by changing the thickness H1 of the pad 20 in the range between 0.5 mm and 10 mm while fixing the width L1 of the semiconductor device 10 at 10 mm, the width L2 of the heat transfer region 35 at 30 mm, the heat transfer coefficient of the heat transfer region 35 at 6000W, and the thickness H2 of the heat transfer region 35 of the insulating board 30 at 0.25 mm. The directions of the width L1, L2 are parallel to the direction substantially orthogonal to the stacking direction. The horizontal axis corresponds to the thickness H1 [mm] of the pad 20, and the vertical axis corresponds to the heat radiation performance [W/W] of the case where the maximum heat radiation performance is 1. The heat radiation performance is a value determined based on the maximum heat radiation amount [W / (m²K)] allowed for the semiconductor device. By setting the maximum heat radiation performance at 1, the influence of the allowable temperature of the semiconductor device can be eliminated.

According to the simulation result, when the thickness H1 of the pad 20 is small, the heat radiation performance is low. When the thickness H1 of the pad 20 is 1.5 mm, approximately 80% of the maximum heat radiation performance could have been achieved, and when the thickness H1 of the pad 20 is 2 mm, approximately 85% of the maximum heat radiation performance could have been achieved. When the thickness H1 of the pad 20 is 4 mm, approximately 98% of the maximum heat radiation performance could have been achieved, when the thickness H1 of the pad 20 is 5 mm, approximately 99% of the maximum heat radiation performance could have been achieved, and when the thickness H1 of the pad 20 is 5 mm or more, heat radiation performance substantially equal to the maximum heat radiation performance could have been achieved. Even when the width L1 of the semiconductor device 10, the width L2 of the heat transfer region 35, and the heat transfer coefficient are changed, substantially the same result as the above simulation result was obtained.

According to the above result, to obtain sufficient heat radiation performance, it is desirable that the thickness H1 of the pad 20 is 1.5 mm or more, and is preferably 2 mm or more. On the other hand, to realize miniaturization, weight savings, and price reduction of the semiconductor package, it is desirable that the thickness H1 of the pad 20 is thin. Accordingly, the thickness H1 of the pad 20 should be the minimum value in the range which allows obtaining substantially the maximum heat radiation performance, and is desirably 5 mm or less, for example. The maximum value of thickness H1 is changed appropriately at the time of designing in consideration of the heat radiation performance and the thickness of the semiconductor package.

FIG. 4 shows an example of the relationship between the thickness and heat radiation performance of a heat transfer region of a wiring board and a semiconductor package of embodiments.

FIG. 4 shows a result of a simulation performed by changing the thickness H2 of the heat transfer region 35 of the insulating board 30 in the range between 0.1 mm and 2 mm while fixing the width L1 of the semiconductor device 10 at 10 mm, the width of the heat transfer region 35 at 30 mm, the heat transfer coefficient at 6000W, and the thickness H1 of the pad 20 at 2 mm relative to the direction substantially orthogonal to the stacking direction. The horizontal axis corresponds to the thickness H1 [mm] of the pad 20, and the vertical axis corresponds to the heat radiation performance of the case where the maximum heat radiation performance is 1. The heat radiation performance is a value determined based on the maximum heat radiation amount [W / (m²K)] allowed for the semiconductor device. By setting the maximum heat radiation performance at 1, the influence of the allowable temperature of the semiconductor device can be eliminated.

According to the simulation result, the heat radiation performance tends to be better when the thickness H2 of the heat transfer region 35 of the insulating board 30 is small, and when thickness H2 is 0.25 mm or less, there was no change in the heat radiation performance [W/W]. Even when the width L1 of the semiconductor device 10, the width L2 of the heat transfer region 35, and the heat transfer coefficient are changed, substantially the same result as the above simulation result was obtained.

If the thickness of the heat transfer region 35 of the insulating board 30 increases, the material cost increases, and it becomes difficult to hold down the unit price of the semiconductor package. In contrast, if the heat transfer region 35 is too thin, the insulating board 30 cannot obtain sufficient strength as a substrate, and is damaged when subjected to shock etc. Thus, the thickness H2 of the heat transfer region 35 may be the minimum thickness which allows obtaining strength as a substrate, such as a thickness of 0.2 mm or more. When the insulating board 30 is formed by stacking ceramic sheets, the thickness H2 of the heat transfer region 35 depends on the thickness per ceramic sheet. Thus, the minimum value of the heat transfer region 35 is, for example, the thickness of one ceramic sheet.

In the case of a 6.5 kV module in a locomotive, for example, 1 mm is enough as a thickness of the heat transfer region 35 to ensure insulation properties. Accordingly, it is desirable that the heat transfer region 35 has a thickness in the range between 0.2 mm and 1 mm, for example.

As described above, a wiring board SB and a semiconductor package with sufficient heat radiation performance can be provided by providing appropriate thicknesses to the pad 20 and the heat transfer region 35 of the insulating board 30 even though only the solder 12, the pad 20, and the heat transfer region 35 are provided between the semiconductor device 10 and the cooling surface 36. Namely, according to the present embodiment, a wiring board and a semiconductor package including the wiring board which have high cooling performance can be provided.

In addition, the semiconductor package of the present embodiment only comprises the semiconductor device 10, the pad 20, the insulating board 30, and the sealing body 40, and has less structures than conventional semiconductor packages, and thus can realize miniaturization, weight savings, and price reduction.

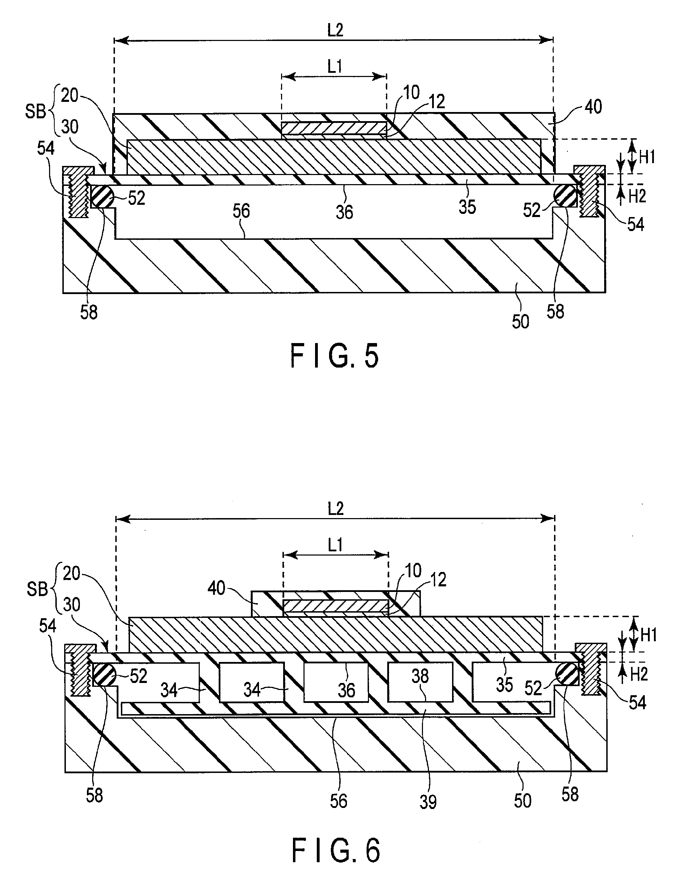

FIG. 5 is a cross-sectional view illustrating an example of the configuration of a wiring board and a semiconductor package of a second embodiment.

In the following descriptions of multiple examples, the same structures as those in the first embodiment will be assigned with the same reference numerals, and descriptions thereof will be omitted. In the present embodiment, the configuration of the insulating board 30 differs from that in the example shown in FIG. 1, and the other structures are the same as those in the example shown in FIG. 1. The semiconductor package of the present embodiment is attached to a flow path jacket 50.

The insulating board 30 includes the heat transfer region 35. In the present embodiment, the insulating board 30 does not have protrusions. Thus, the cooling surface 36 of the heat transfer region 35 is substantially flat. The heat transfer region 35 includes, at its end, a screw hole in which a screw 54 for fastening the flow path jacket 50 is inserted.

The flow path jacket 50 includes a depressed portion 56 and a step 58. The depressed portion 56 is provided in a center in the board surface direction. The depressed portion 56 faces the heat transfer region 35, and a gap between the depressed portion 56 and the heat transfer region 35 serves as a flow path for the cooling medium. The step 58 is provided inside of the portion where the heat transfer region 35 is screwed to the flow path jacket 50. An O-ring 52 is provided on the step 58. The O-ring 52 is elastic, and is interposed between the heat transfer region 35 and the step 58 to seal a space between the insulating board 30 and the flow path jacket 50.

As described above, in the semiconductor package of the present embodiment, a flow path of the cooling medium is formed between the insulating board 30 and the flow path jacket 50 by attaching the flow path jacket 50 to the insulating board 30. The flow path jacket 50 may not be made of ceramic, and may be made of, for example, a metal material such as aluminum, or a resin material.

In this example, to obtain sufficient heat radiation performance, it is desirable that the thickness H1 of the pad 20 is 1.5 mm or more, and is preferably 2 mm or more. To realize miniaturization, weight savings, and price reduction of the semiconductor package, it is desirable that the thickness H1 of the pad 20 is 5 mm or less.

The thickness H2 of the heat transfer region 35 may be the requisite minimum, and is desirably in the range between 0.2 mm and 1 mm, for example.

By providing appropriate thicknesses to the pad 20 and the insulating board 30 as described above, a wiring board and a semiconductor package including the wiring board which have high cooling performance can be provided, as in the above-described embodiment. In addition, the semiconductor package according to this example has less structures than conventional semiconductor packages, and thus can realize miniaturization, weight savings, and price reduction.

FIG. 6 is a cross-sectional view illustrating an example of the configuration of a wiring board and a semiconductor package of a third embodiment.

In the present embodiment, the configurations of the insulating board 30 and the sealing body 40 differ from those in the example shown in FIG. 1, and the other structures are the same as those in the example shown in FIG. 1. The semiconductor package of the present embodiment is attached to the flow path jacket 50.

The insulating board 30 includes a heat transfer region 35, a plurality of protrusions 34, and a plate portion 39. The heat transfer region 35 includes, at its end, a screw hole in which a screw 54 for fastening to the flow path jacket 50 is inserted.

The plate portion 39 includes a counter surface 38 to the cooling surface 36. The counter surface 38 is continuous with ends of the protrusions 34. Namely, one end of each of the protrusions 34 is continuous with the heat transfer region 35 and the other end thereof is continuous with the counter surface 38. The heat transfer region 35, the protrusions 34, and the counter surface 38 are integrally formed by ceramic, such as silicon nitride. Since ceramic contracts when sintered, the other end of each of the protrusions 34 is connected to the counter surface 38 to prevent bending of the insulating board 30 in the present embodiment.

The sealing body 40 covers the semiconductor device 10 while leaving a part of the pad 20 exposed. The exposed portion of the pad 20 can be connected to a lead or a bus bar. The structures other than the above are the same as those of the semiconductor package shown in FIG. 5. Accordingly, the flow path jacket 50 includes the depressed portion 56 and the step 58. In the semiconductor package of the present embodiment, a flow path of the cooling medium is formed between the insulating board 30 and the flow path jacket 50 by attaching the flow path jacket 50 to the insulating board 30. The flow path jacket 50 is connected via, for example, a low heat conducting sealing material, and thus does not require heat radiation performance, and may be made of any material which allows formation of the flow path. The flow path jacket 50 may not be made of ceramic, and may be made of, for example, a metal material such as aluminum, or a resin material.

In this example, to obtain sufficient heat radiation performance, it is desirable that the thickness H1 of the pad 20 is 1.5 mm or more, and is preferably 2 mm or more. To realize miniaturization, weight savings, and price reduction of the semiconductor package, it is desirable that the thickness H1 of the pad 20 is 5 mm or less.

The thickness H2 of the heat transfer region 35 may be the requisite minimum, and is desirably in the range between 0.2 mm and 1 mm, for example.

By providing appropriate thicknesses to the pad 20 and the insulating board 30 as described above, a wiring board and a semiconductor package including the wiring board which have high cooling performance can be provided, as in the above-described embodiment. In addition, the semiconductor package according to this example has less structures than conventional semiconductor packages, and thus can realize miniaturization, weight savings, and price reduction.

While certain embodiments have been described, these embodiments have been presented by way of example only, and are not intended to limit the scope of the inventions. Indeed, the novel methods and systems described herein may be embodied in a variety of other forms; furthermore, various omissions, substitutions, and changes in the form of the methods and systems described herein may be made without departing from the spirit of the inventions. The accompanying claims and their equivalents are intended to cover such forms or modifications as would fall within the scope and spirit of the inventions.

For example, in the first embodiment, the protrusions 34 of the insulating board 30 may be omitted. Even in such a case, the same advantage as that performed by the wiring board and the semiconductor package of the first embodiment can be performed. In the first and second embodiments, the sealing body 40 may be provided in such a manner as to expose a part of the pad 20 and cover the semiconductor device 10. Even in such a case, the same advantage as that performed by the first and second embodiments can be performed. In the second and third embodiments, the method of fastening the wiring board SB to the flow path jacket 50 is not limited to the above-described one.

## Claims

1. A wiring board (SB) comprising:
an insulating board (30) including a heat transfer region (35) made of silicon nitride and having a thickness in a range between 0.2 mm and 1 mm; and
a wiring layer including a pad (20) stacked on the heat transfer region (35) and made of a metal material having a thickness of 1.5 mm or more.

2. The wiring board (SB) according to Claim 1, wherein the thickness of the pad (20) is in a range between 2 mm and 5 mm.

3. The wiring board (SB) according to Claim 1 or 2, wherein the insulating board (30) includes a cylinder having a surface opposed to a surface on which the pad is stacked as a part of an inner surface.

4. The wiring board (SB) according to any one of Claims 1 to 3, wherein the heat transfer region (35) includes a plurality of protrusions (34) on a surface (36) opposed to a surface on which the pad (20) is stacked.

5. The wiring board (SB) according to Claim 4, wherein the insulating board (30) further comprises a plate portion (36) including a counter surface continuous with an end of each of the plurality of protrusions (34).

6. A semiconductor package comprising: the wiring board (SB) according to any one of Claims 1 to 5; a semiconductor device (10) joined on the pad (20) of the wiring board (SB); and
a sealing body (40) which seals the semiconductor device (10).
